# EUROPÄISCHE PATENTSCHRIFT

(11) **EP 0 824 302 B1**
(45) Veröffentlichungstag und Bekanntmachung des Hinweises auf die Patenterteilung: **16.05.2001**
(21) Anmeldenummer: 97113475.4
(22) Anmeldetag: 05.08.1997
(51) Int. Cl.: H05K 7/20, H05K 7/14

(54) **Elektronisches Gerät in Modulbauweise**
Modular electronic apparatus
Appareil électronique modulaire

(30) Priorität: 13.08.1996 DE 19632545
(43) Veröffentlichungstag der Anmeldung: 18.02.1998
(73) Patentinhaber: Bodenseewerk Gerätetechnik GmbH, 88662 Überlingen (DE)
(72) Erfinder: Neumann, Werner, 88696 Owingen (DE)
(74) Vertreter: Weisse, Jürgen, Dipl.-Phys.

(56) Entgegenhaltungen:
- US-A- 3 956 673
- US-A- 4 179 724
- US-A- 4 375 290
- US-A- 5 388 995
- US-A- 5 424 916

## Beschreibung

Die Erfindung betrifft ein elektronisches Gerät in Modulbauweise mit Leiterplatten, die elektronische Bauteile tragen, bei welchem die Leiterplatten parallel zueinander in einem Modul-Rahmen in Einschub-Modulen angeordnet sind, welche ihrerseits nebeneinander in einen Kabinett-Rahmen herausziehbar gehaltert sind, wobei die Einschub-Module mit einer Rückwand-Baugruppe elektrisch verbunden sind, wobei
(a) der Modul-Rahmen von einem rechteckigen Rahmenteil gebildet ist,
(b) Leiterplatten als Strukturteile des Einschub-Moduls auf beiden Seiten auf den Rahmenteil aufgesetzt sind und
(c) in die Leiterplatten Wärmeableit-Mittel zur Ableitung von Wärme von den Bauteilen integriert sind.

Ein bekannter Aufbau elektronischer Geräte enthält einen "Kabinett-Rahmen", in welchen Einschub-Module mit Leiterplatten einschiebbar sind. Der Kabinett-Rahmen enthält eine quaderförmige Rahmenstruktur mit parallelen Führungen für schmale Einschub-Module. Die Einschub-Module sind parallel zueinander, nebeneinander in dem Kabinett-Rahmen gehalten. Eine Rückwandbaugruppe schließt den Kabinett-Rahmen auf der Rückseite ab. Die Rückwand-Baugruppe ist mit Steckersockeln versehen, in welche Verbindungs-Stecker auf der hinteren Stirnseite der Einschub-Module einsteckbar sind. Über diese Verbindungs-Stecker und die Steckerbuchsen sind die Leiterplatten der verschiedenen Einschub-Module miteinander und mit der Verdrahtung des Gesamtsystems, z.B. eines Flugzeugs, verbunden. Bei den bekannten Anordnungen weist jedes der Einschub-Module einen Modul-Rahmen in Form eines Gehäuses auf, in welchem die Leiterplatten gehaltert sind.

Die elektrische Verbindung zwischen den Einschub-Modulen und der Rückwand-Baugruppe erfolgt bei den bekannten Geräten über Stecker-Verbindungen mit vielpoligen Steckern, die in entsprechende vielpolige Steckersockel einsteckbar sind. Die verschiedenen Leiterbahnen der Einschub-Module sind mit je einem Steckerstift des vielpoligen Steckers verbunden, und die verschiedenen Leiterbahnen der Rückwand-Baugruppe sind mit je einer Steckerbuchse des Steckersockels verbunden (oder umgekehrt).

So aufgebaute elektronische Geräte haben den Vorteil, daß Defekte und Ausfälle leicht zu lokalisieren und defekte Einschub-Module sehr einfach auszuwechseln sind. Nachteilig ist bei bekannten Geräten dieser Art ein recht hohes Gewicht des Gerätes und ein relativ großer Raumbedarf. Das ist bei vielen Anwendungen, z.B. in Flugzeugen, ein schwerwiegender Nachteil. Das Einstecken der vielpoligen Stecker in die vielpoligen Steckersockel und das Herausziehen des Steckers aus dem Steckersockel erfordert eine erhebliche Kraft. Aus diesem Grunde sind zum Herausziehen der Einschub-Module aus dem Kabinett-Rahmen komplizierte Griffbügel mit Hebeluntersetzung vorgesehen. Auch sind bekannte Geräte aufwendig und damit teuer in der Herstellung.

Durch die US-A-3 956 673 ist ein elektronisches Gerät in Modulbauweise mit Leiterplatten bekannt, die elektronische Bauteile tragen. Die Leiterplatten sind parallel zueinander in einem Modul-Rahmen in Einschub-Modulen angeordnet. Der Modul-Rahmen ist von einem rechteckigen Rahmenteil gebildet. Leiterplatten sind als Strukturteile des Einschub-Moduls auf beiden Seiten auf den Rahmenteil aufgesetzt. Die Leiterplatten weisen einander abgewandten Bestückungsseiten auf. Die einander zugewandten Seiten der Leiterplatten sind nicht bestückt. An diesen unbestückten einander zugewandten Seiten der Leiterplatten sind Wärmeableit-Mittel in Form einer durchgehenden Metallschicht vorgesehen. An dieser Metallschicht sind Luftleitkörper befestigt. Durch diese Luftleitkörper wird zwischen jeweils zwei Leiterplatten einströmende Kühlluft zur besseren Kühlung gleichmäßig im Raum zwischen den Leiterplatten verteilt.

Die US-A-3 956 673 zeigt ein ähnliches Gerät mit Leiterplatten, welche ebenfalls einander abgewandten Bestückungsseiten aufweisen, wobei die einander zugewandten Seiten der Leiterplatten unbestückt sind. Zwischen den Leiterplatten ist eine Wärmesenke vorhanden. Die Wärmesenke besteht aus zwei parallelen planen Flächen, zwischen welchen Druchflußkanäle gebildet sind.

Der Erfindung liegt die Aufgabe zugrunde, bei Geräten der eingangs genannten Art durch einen geeigneten konstruktiven Aufbau Gewicht, Raumbedarf und Kosten zu reduzieren.

Erfindungsgemäß wird diese Aufgabe dadurch gelöst, daß
(d) die Leiterplatten einander zugewandten Bestückungsseiten aufweisen, und
(e) die Wärmeableit-Mittel wärmeleitende Metallflächen auf den einander zugewandten Bestückungsseiten der Leiterplatten aufweisen, die wiederum durch wärmeleitende, metallische Flächen mit wärmeerzeugenden Bauteilen verbunden sind, und mit diesen Metallflächen wärmeleitend verbundene Wärmesenken.

Auf diese Weise bilden die Einschub-Module schmale und leichte Strukturen. Der Modul-Rahmen ist nur ein schmales, rechteckiges Rahmenteil. Die Seitenwände des Einschub-Moduls werden von den Leiterplatten selbst gebildet. Die Leiterplatten bilden daher ein Strukturteil des Einschub-Moduls. Man kann auch andersherum sagen, daß Strukturteile des Einschub-Moduls als Leiterplatten dienen. Die Leiterplatten sind an den einander zugewandten Seiten bestückt. Dadurch lassen sich die Einschub-Module als schmale Baugruppen ausbilden, die dicht nebeneinander in dem Kabinett-Rahmen sitzen. Dadurch können bei einer bestimmten Anzahl von Einschub-Modulen die Abmessungen des Kabinett-Rahmens verringert werden. Das elektronische Gerät wird leichter und kompakter. Es ergibt sich auch eine konstruktive und fertigungstechnische Vereinfachung und damit eine Verminderung der Kosten. Bei einer solchen Konstruktion ergibt sich aber eine höhere Verdichtung der elektronischen Bauteile. Solche elektronischen Bauteile entwickeln in erheblichem Maße Verlustwärme. Dieses Wärmeproblem verschärft sich mit der durch die Erfindung ermöglichten Verdichtung der Bauteile im Gerät. Die Erfindung beruht auch auf der Erkenntnis, daß diese Probleme sich lösen lassen, wenn, wie oben angegeben, in die Leiterplatten Wärmeableit-Mittel zur Ableitung von Wärme von den Bauteilen integriert sind, wobei die Wärmeableit-Mittel wärmeleitende Metallflächen auf den einander zugewandten Bestückungsseiten der Leiterplatten aufweisen, die wiederum durch wärmeleitende, metallische Flächen mit wärmeerzeugenden Bauteilen verbunden sind, und mit diesen Metallflächen wärmeleitend verbundene Wärmesenken. Dabei können die Wärmesenken von wärmeleitenden Brückenteilen gebildet sein, die sich zwischen gegenüberliegenden Metallflächen einander zugewandter Bestückungsseiten der benachbarten Leiterplatten erstrecken. Die als Wärmesenken dienenden Brückenteile können mit Kühlrippen versehen sein. Weiterhin können die mit den Wärmesenken verbundenen Metallflächen sich durch die Leiterplatten hindurch erstrecken und mit auf den unbestückten Außenseiten der Leiterplatten vorgesehenen Metallschichten wärmeleitend verbunden sein.

Die in den Bauteilen entwickelte Wärme wird dann von den Bauteilen über die wärmeleitenden metallischen Flächen der Leiterplatten zu den damit verbundenen Metallflächen geleitet. Dort wird die Wärme von den Wärmesenken aufgenommen und über die daran vorgesehenen Rippen an denzwischen den Leiterplatten kaminartig aufsteigenden Luftstrom abgegeben. Die Metallflächen können sich aber auch durch die Leiterplatte hindurch erstrecken und dort Wärme an eine Metallschicht abgeben, die auf der unbestückten Außenseite der Leiterplatten vorgesehen ist. Über diese Metallschicht kann die Wärme an die Rahmen-Struktur abgegeben werden.

Um eine möglichst schmale Ausbildung der Einschub-Module zu ermöglichen, d.h. den Abstand der Leiterplatten möglichst gering halten zu können, können auf jeder Leiterplatte Bereiche mit weiter vorstehenden Bauteilen jeweils Bereichen mit weniger weit vorstehenden Bauteilen der anderen Leiterplatte gegenüberliegen, wobei die Leiterplatten so dicht benachbart angeordnet sind, daß sich in Längsrichtung der Leiterplatten gesehen die weiter vorstehenden Bauteile überlappen. Das kann in der Weise geschehen, daß die beiden Leiterplatten übereinstimmend ausgebildet sind, wobei auf jeder Leiterplatte die Bereiche mit weiter vorstehenden Bauteilen in Bezug auf eine Mittellinie symmetrisch zu Bereichen mit weniger weit vorstehenden Bauteilen angeordnet sind.

Zusätzlich zu den oben erwähnten Wärmeableit-Mittel können auf den Außenseiten der Leiterplatten Sandwich-Platten angebracht sein, die aus durch eine Wellenstruktur verbundenen Metall-Schichten besteht, wobei die Wellenstruktur mit den Metall-Schichten vertikale Kanäle bildet. Die Metall-Schichten können dabei Aluminium-Schichten sein. Solche Sandwich-Platten sind handelsüblich für andere Zwecke erhältliche, relativ preisgünstige Materialien.

Die Leiterplatten können auch auf den Außenseiten mit Bauteilen bestückt sein und die auf den Außenseiten montierten Bauteile in Durchbrüche der Sandwich-Platten hineinragen.

Um das Einschieben und Herausziehen der Einschub-Module zu erleichtern, kann die elektrische Verbindung der Module mit der Rückwand-Baugruppe über federnd angedrückte Oberflächen-Kontakte herstellbar sein.

Ausgestaltungen der Erfindung sind Gegenstand weiterer Unteransprüche.

Ausführungsbeispiele der Erfindung sind nachstehend unter Bezugnahme auf die zugehörigen Zeichnungen näher erläutert.
- Fig. 1: ist eine teilweise abgebrochene, perspektivische Darstellung eines Kabinett-Rahmens, in welchen eine Mehrzahl von Einschub-Modulen eingeschoben ist.
- Fig.2: ist eine auseinandergefaltet-perspektivische Darstellung des Aufbaus eines einzelnen Einschub-Moduls.
- Fig.3: ist eine abgebrochen und auseinandergezogen-perspektivische Darstellung und zeigt schematisch eine andere Ausführung der Wärmeableit-Mittel bei dem Einschub-Modul.
- Fig.4: ist ein abgebrochener Querschnitt durch eine Leiterplatte und zeigt eine Einzelheit einer Metallfläche bei den Wärmeableit-Mitteln von Fig.3.
- Fig.5: ist eine perspektivische Darstellung und zeigt die beiden Leiterplatten des Einschub-Moduls von Fig.2 mit der Anordnung der Bauteile auf den einander zugewandten Bestückungsseiten der Leiterplatten.
- Fig.6: ist eine auseinandergezogen-perspektivische Darstellung einer anderen Ausführung eines Einschub-Moduls.
- Fig.7: ist eine abgebrochen-perspektivische Darstellung und zeigt das Material von Sandwich-Platten, das bei der Ausführung des Einschub-Moduls von Fig.6 verwendet wird.
- Fig.8: ist eine abgebrochen-perspektivische Darstellung und zeigt eine mit Aussparungen versehene Sandwich-Platte und -abgeklappt- die mit Bauteilen bestückte Außenseite einer dazu benachbarten Leiterplatte, wobei im montierten Zustand die Bauteile in die Aussparungen hineinragen.
- Fig.9: zeigt den Aufbau eines Kabinett-Rahmens und eines den Kabinett-Rahmen auf der Rückseite abschließenden Rückwand-Bauteil (Back Plane).
- Fig.10: ist eine perspektivisch-auseinandergezogene Darstellung und zeigt einen zweiteiligen Kabinett-Rahmen.
- Fig.11: ist eine abgebrochen-perspektivische Darstellung und zeigt die Kontaktierung zwischen Einschub-Modul und Rückwand-Baugruppe.
- Fig.12: ist eine schematische Darstellung und zeigt einen Horizontalschnitt durch einen Einschub-Modul und die Rückwand-Baugruppe und zeigt eine Möglichkeit der Oberflächen-Kontaktierung.
- Fig.13: zeigt ein für die Oberflächen-Kontaktierung benutztes (an sich bekanntes) Kontaktelement.

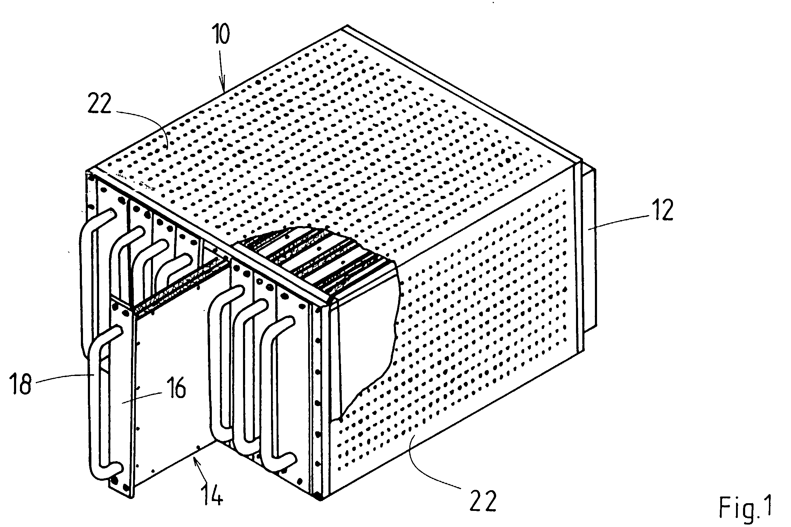

In Fig.1 ist mit 10 ein "Kabinett-Rahmen" bezeichnet. Das ist ein quaderförmiger, nach vorn in Fig.1 offener Kasten. Auf der Rückseite in Fig.1 ist der Kabinett-Rahmen durch einen Rückwand-Bauteil (Back Plane) 12 abgeschlossen. In Führungen, die in Fig.1 nicht sichtbar sind, sind flache, rechteckige Einschub-Module 14 parallel zueinander und eng aneinander anschließend eingeschoben. Die Einschubmodule 14 schließen den Kabinett-Rahmen 10 mit ihren aneinandergrenzenden Frontplatten 16 vorn ab. An den Frontplatten 16 sitzen Griffbügel 18, mittels derer die Einschub-Module 14 im Bedarfsfalle nach vorn herausgezogen werden können, wie in Fig.1 dargestellt ist. Die Seitenflächen des Kabinett-Rahmens 10 sind von perforierten Blechen 22 gebildet.

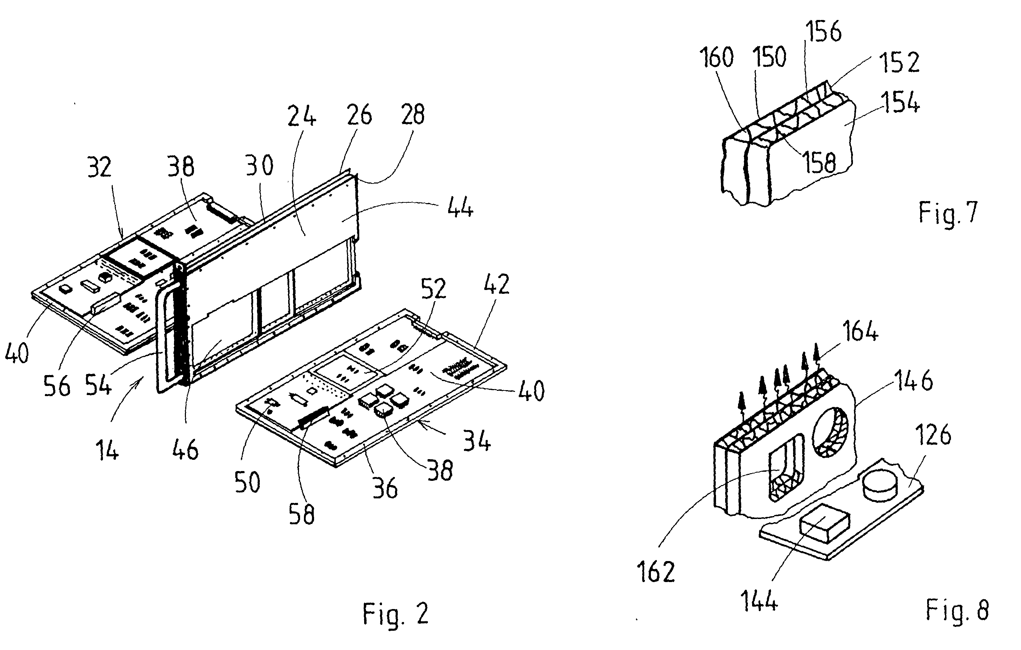

Wie am besten aus Fig.2 ersichtlich ist, enthalten die Einschub-Module 14 jeweils einen in der Mitte liegenden Modul-Rahmen, der von einem rechteckigen, schmalen, Rahmenteil 24 gebildet ist. An seinen Schmalseiten, d.h. seinen Längs- und Stirnseiten, bildet der Rahmenteil 24 vorstehende Flansche 26 und 28. Die Flansche 26 und 28 sind mit Schraublöchern 30 versehen.

Auf den Rahmenteil 24 sind auf beiden Seiten Leiterplatten 32 und 34 aufgesetzt, deren Abmessungen im wesentlichen den Abmessungen des rechteckigen Rahmenteils 24 entsprechen. Die Leiterplatten 32 und 34 sind längs ihrer Ränder mit Schraublöchern 36 versehen und durch (nicht dargestellte) Schrauben mit dem Rahmenteil verbunden. Die Leiterplatten 32 und 34 bilden somit Strukturteile des Einschub-Moduls 14 und praktisch die Seitenwände eines Gehäuses des Einschubmoduls 14.

Die Leiterplatten 32 und 34 weisen einander zugewandte Bestückungsseiten 38 und 40 auf. Auf den Bestückungsseiten der Leiterplatten 32 und 34 sitzen elektronische Bauteile, z.B. 38. Die elektronischen Bauteile sind zum Teil integrierte Schaltungen.

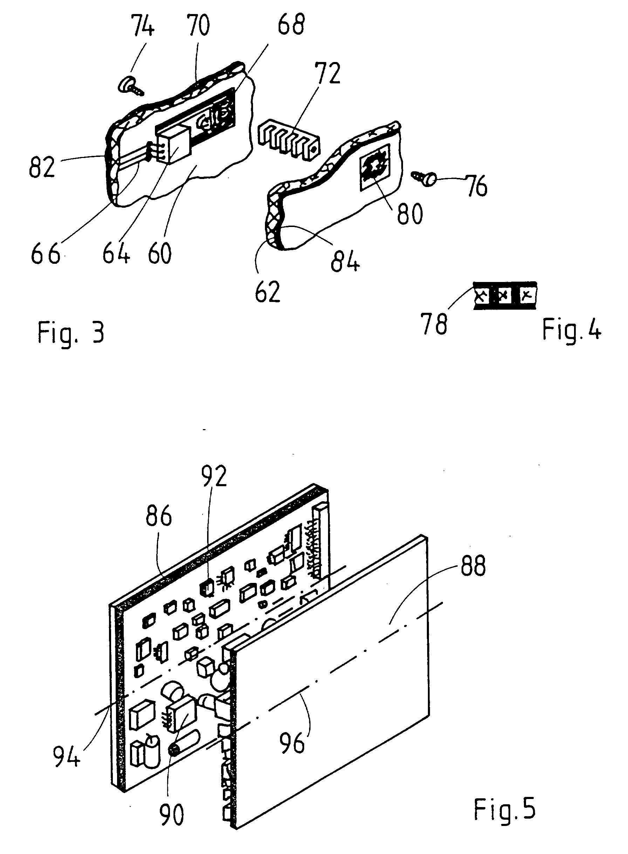

Bei der Ausführung von Fig.2 bilden die Leiterplatten 32 und 34 vorstehende Ränder 40 bzw. 42, die mit dem Rahmenteil 24 verschraubt sind. Das Rahmenteil 24 bildet bei der Ausführung von Fig.2 eine Trennwand 44 in der in Fig.3 oberen Hälfte. Die Oberfläche der Trennwand 44 fluchtet mit der leiterplattenseitigen Oberfläche des Flansches 28. In der in Fig.2 unteren Hälfte bildet das Rahmenteil 24 eine Trennwand 46. Im Mittelteil der Trennwand 46 ist ein rechteckiger Rahmen 48 gebildet. Der Rahmen 48 erstreckt sich von der in Fig.2 hinteren Tennwand 46 bis zur Ebene der in Fig.2 vorderen Oberfläche der Trennwand 44. Ein entsprechender, in Fig.2 nicht sichtbarer Rahmen ist auf der in Fig.2 hinteren Oberfläche der Trennwand 44 gebildet.

Flache Bauteile, z.B. 38, in der in Fig.2 oberen Hälfte der Leiterplatte 34 (vorn auf der umgeklappten Leiterplatte in in Fig.2 zu sehen) sind in dem durch den Rand 42 zwischen der Leiterplatte 34 und der Tennwand 24 gebildeten Raum untergebracht. Weiter vorstehende Bauteile, z.B. 50, sitzen in der in Fig.2 unteren Hälfte der Leiterplatte 34 und sind in dem zwischen der Leiterplatte 34 und der Trennwand in Fig.2 hinteren 46 gebildeten Raum untergebracht. Ein Bauteil 52 sitzt in dem innerhalb des Rahmens 48 gebildeten Raum. Die beiden Leiterplatten 32 und 34 sind in identischer Weise bestückt. Da aber die eine Leiterplatte 32 mit der Bestückungsseite 38 nach vorn und die andere Leiterplatte 34 mit der Bestückungsseite nach hinten in Fig.2 an das Rahmenteil 24 angesetzt ist, liegt jeweils die obere Hälfte einer Leiterplatte der unteen Hälfte der anderen Leiterplatte gegenüber.

An der in Fig.2 vorderen Stirnfläche des Rahmenteils 24 ist ein Griffbügel 54 angebracht.

Über Steckverbindungen 56 und 58, die auf den Mittellinien der Leiterplatten 32, 34 sitzen, sind die beiden Leiterplatten 32 und 34 elektrisch miteinander verbunden.

Bei dieser Ausführung dienen die Trennwände 44 und 46 des Rahmenteils 24 als Wärmeableit-und Schirmungs-Mittel, durch welche einerseits die Wärme von den Bauteilen 38 oder 50 auf das Rahmenteil 24 übertragen und zum Kabinett-Rahmen abgeführt wird und andererseits eine Abschirmung von störanfälligen Bauteilen erfolgt.

Eine andere Art der Wärmeableitung ist in Fig.4 dargestellt.

Dort sind zwei Leiterplatten 60 und 62 mit ihren Bestückungsseiten einander zugewandt angeordnet. Auf der Leiterplatte 60 sitzt ein als integrierte Schaltung ausgebildetes elektronisches Bauteil 64. Mit 66 sind Leiterbahnen bezeichnet, die zu dem Bauteil 64 geführt sind. Zur Ableitung der Verlustwärme von dem Bauteil 64 ist auf der Leiterplatte 60 eine Metallfläche 68 gebildet. Die Metallfläche 68 ist über eine wärmeleitende metallische Fläche 70 mit dem Bauteil 64 verbunden. Eine entsprechende, in Fig.4 nicht sichtbare Metallfläche ist fluchtend mit der Metallfläche 68 auf der Bestückungsseite der Leiterplatte 62 vorgesehen. Zwischen den Leiterplatten 60 und 62 erstreckt sich eine Wärmesenke 72. Die Wärmesenke 72 ist mit Kühlrippen versehen. Durch Kaminwirkung entsteht ein Luftstrom in dem Zwischenraum zwischen den Leiterplatten 60 und 62, durch den Wärme abgeführt wird. Die Wärmesenke 72 ist durch Schrauben 74 und 76 gehalten.

Wie aus Fig.4 ersichtlich ist, sind die Metallfläche 68 der Leiterplatte 60 und die entsprechende Gegenfläche der Leiterplatte 62 mit Metallflächen auf den Außenseiten der Leiterplatten 60 bzw. 62 über wärmeleitende Durchführungen 78 verbunden. In Fig.4 ist die auf der Außenseite der Leiterplatte 62 gebildete Metallfläche 80 sichtbar. Dadurch wird Wärme von den Bauteilen 64, soweit sie nicht durch den Luftstrom an der Wärmesenke 72 abgeführt wurde, auf die Außenseite der Leiterplatten 60 und 62 geleitet.

Wie in Fig.3 dargestellt ist, sind auf den Außenseiten der Leiterplatten 60 und 62 Metallschichten 82 bzw. 84 gebildet. Diese strahlen die Wärme ab ode leiten sie zu dem Kabinett-Rahmen 10 (Fig.3) weiter.

Die Metallflächen 68, metallischen Flächen 70 und die Metallschichten 82 und 84 bestehen aus Kupfer.

Fig.5 ist eine auseinandergezogen-perspektivische Darstellung und zeigt die Bestückung zweier mit ihren Bestückungsseiten einander zugewandter Leiterplatten 86 und 88. Die beiden Leiterplatten 86 und 88 sind übereinstimmend ausgebildet und bestückt. Auf der in Fig.5 unteren Hälfte der Leiterplatte 86 sind Bauteile 90 angeordnet, die relativ weit von der Oberfläche der Leiterplatte 86 vorstehen. Auf der in Fig.5 oberen Hälfte der Leiterpatte 86 sind Bauteile 92 angeordnet, die weniger weit von der Oberfläche der Leiterplatte 86 vorstehen. Die beiden Hälften oder Bereiche sind durch eine Mittellinie 94 voneinander getrennt. Die übereinstimmend ausgebildete und bestückte Leiterplatte 88 ist mit ihrer Bestückungsseite der Leiterplatte 86 zugewandt und zeigt nach hinten in Fig.5. Die Leiterplatte 88 ist daher gegenüber der Leiterplatte 86 um ihre Mittellinie 96 um 180° gedreht angeordnet. Die Hälfte mit den weiter vorstehenden Bauteilen liegt daher bei der Leiterplatte 88 oben in Fig.5 und den weniger weit vorstehenden Bauteilen 92 der Leiterplatte 86 gegenüber. Die Hälfte mit den weniger weit vorstehenden Bauteilen liegt bei der Leiterplatte 88 unten in Fig.5 und den weiter vorstehenden Bauteilen 90 der Leiterplatte 86 gegenüber. Auf diese Weise können die Leiterplatten 86 und 88 so weit einander angenähert werden, daß sich die weiter vorstehenden Bauteile der der beiden Leiterplatten von oben in Fig.5 gesehen überlappen. Der Abstand der Leiterplatten 86 und 88 wird dadurch reduziert. Die Einschub-Module 14 (Fig.1) werden schmaler.

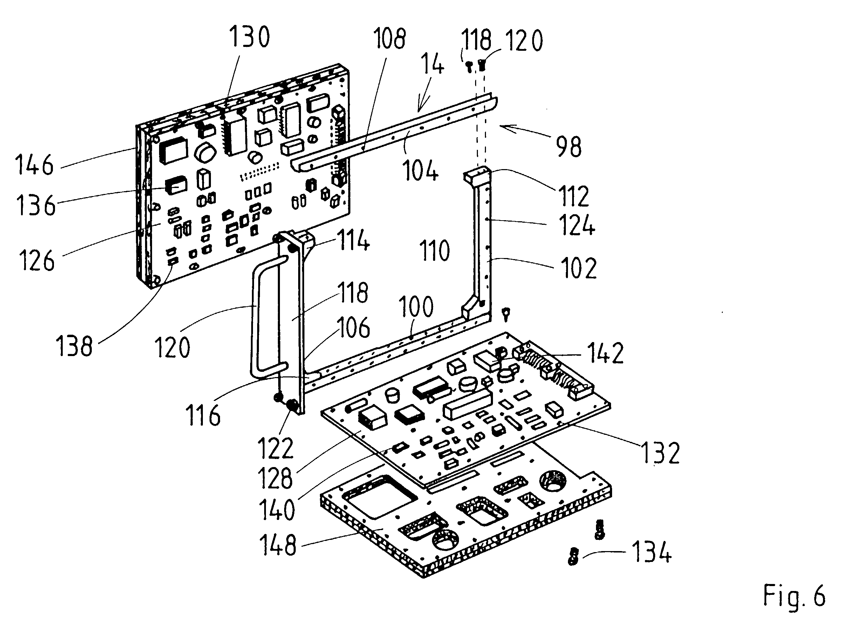

Eine abgewandelte Ausführung eines Einschub-Moduls ist in Fig.6 in auseinandergezogen- bzw. abgeklapptperspektivischer Darstellung gezeigt.

Bei der Ausführung nach Fig.6 ist der innere Rahmenteil 98 ein rechteckiger Bauteil aus vier geraden Umfangsteilen 100, 102, 104 und 106. Die einander gegenüberliegenden, Umfangsteile 100 und 104 sind U-Profile, deren Flansche Befestigungslöcher 108 bilden. Die Umfangsteile 100 und 104 sind durch die Umfangsteile 102 und 106 miteinander verbunden. Die Umfangsteile 102 und 106 sitzen mit Fußteilen 110 und 112 bzw. 114 und 116 auf den Innenseiten der Umfangsteile 100 und 114 an deren Enden auf und sind durch Schrauben 118 und 120 mit diesen verbunden, wie für Fußteil 112 und Umfangsteil 104 dargestellt ist. Die Umfangsteile bilden so einen zu den Seiten, nach vorn und hinten in Fig.6, hin offenes Rahmenteil 98. Auf der Außenseite des Umfangsteils 106 ist eine Frontplatte 118 mit einem Griffbügel 120 durch Schrauben 122 befestigt. Die Umfangsteile 102 und 106 weisen ebenfalls Schraublöcher 124 auf. Mit 126 und 128 sind zwei Leiterplatten bezeichnet. Die Leiterplatten 126 und 128 weisen an ihren Rändern Schraublöcher 130 bzw. 132 auf Die Leiterplatten sind durch Schrauben 134 auf gegenüberliegenden Seiten mit dem Rahmenteil 98 verschraubt. Auf den Innenseiten der Leiterplatten 126 und 128 sind dabei Bauteile wieder so angeordnet, daß auf der in Fig.6 oberen Hälfte der Leiterplatte 126 weiter vorstehende Bauteile 136 und auf der in Fig.6 unteren Hälfte der Leiterplatte 126 weniger weit vorstehende Bauteile 138 angeordnet sind. Auf der Leiterplatte 128, die mit der Bestückungsseite nach hinten in Fig.6 weist, sitzen dagegen die weniger weit vorstehenden Bauteile 140 im montierten Zustand oben und die weiter vorstehenden Bauteile 142 unten. Die Verhältnisse sind ähnlich wie bei der Anordnung von Fig.5.

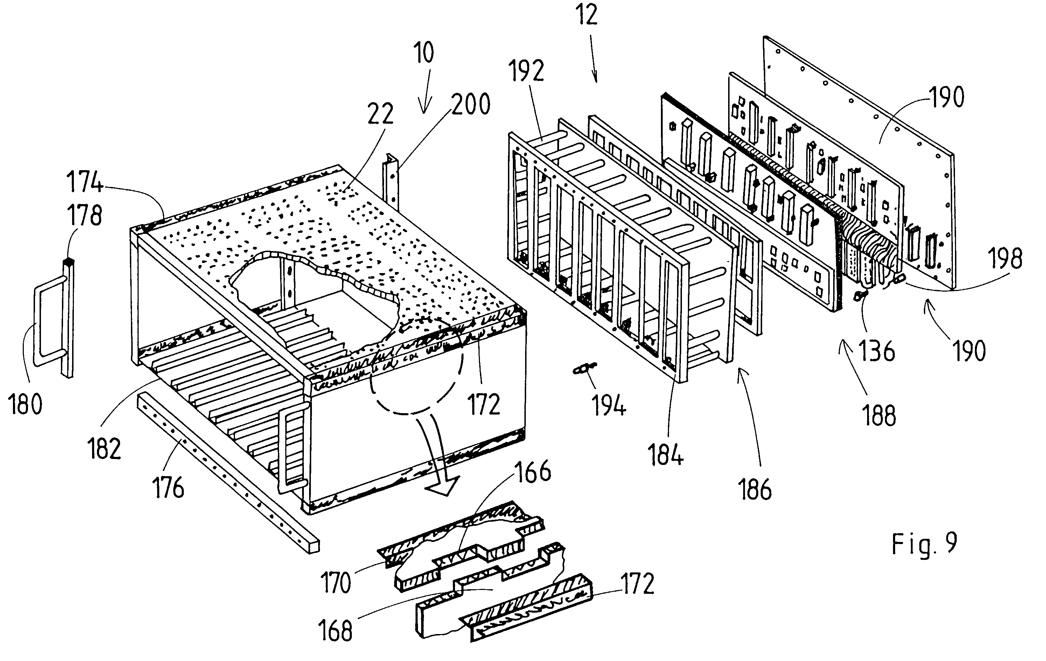

Bei dem Einschub-Modul 14 von Fig.6 sind die Leiterplatten 126 und 128 auch auf den Außenseiten mit Bauteilen 144 (Fig.8) bestückt. Diese sind in Fig.6 nicht sichtbar. Auf den Außenseiten der Leiterplatten 126 und 128 sind Sandwich-Platten 146 bzw. 148 angebracht. Die Sandwich-Platten 146 und 148 bestehen drei Metall-Schichten 150, 152 und 154, die jeweils durch Wellen-Strukturen 156 bzw. 158 miteinander verbunden sind. Dabei bilden die Wellenstrukturen 156 und 158 mit den Metall-Schichten 150, 152 bzw 152, 154 vertikale Kanäle 160. Das ist am besten aus Fig.7 ersichtlich. Die Metall-Schichten 150, 152 und 154 und die Wellen-Strukturen 156 und 158 bestehen aus Aluminium. Solche Sandwich-Platten sind als Massen-Halbzeug handelsüblich und preisgünstig erhältlich. Wie aus Fig.8 ersichtlich ist, weisen die Sandwich-Platten 146 und 148 Aussparungen 162 auf, in welche die auf den Rückseiten der Leiterplatten montierten Bauteile 144 hineinragen. Wie in Fig.8 durch gewellte Pfeile angedeutet ist, wirken die vertikal angeordneten Kanäle der Sandwich-Platten 148 oder 148 als Kühlkanäle, in denen durch Kaminwirkung ein Kühlluftstrom erzeugt wird.

Die beschriebene Wärmeableitung durch luftdurchströmte Sandwich-Platten kann auch in Kombination mit den unter Bezugnahme auf die Figuren 2 bis 5 beschriebenen wärmeableitenden Maßnahmen angewandt werden.

Fig.9 ist eine auseinandergezogen-perspektivische Darstellung des Kabinett-Rahmens 10. Der Kabinett-Rahmen 10 ist mit vier rechteckigen, perforierten Blechen 22 aufgebaut. Die Bleche 22 sind an ihren seitlichen Rändern durch Ineinanderfügen von rechteckigen Ausschnitten 166 eines Blechs und zwischen solchen Ausschnitten gebildeten rechteckigen Vorsprüngen 168 des jeweils anderen Teils miteinander Verbunden. Innen in die so gebildeten Kanten und außen auf die Kanten sind L-Profilleisten 170 bzw. 172 geklebt. Die L-Profilleisten an den Kanten sind vorn, oben und unten durch Querstreben 174 bzw. 176 miteinander verbunden. Vor die Stirnflächen der vertikalen Seitenwände 22 sitzen Leisten 178 mit Griffbügeln 180.

Auf der unteren Innenfläche des Kabinett-Rahmens 10 sind längsverlaufende Führungsleisten 182 angebracht.Auf den Führungsleisten 182 sind die Einschub-Module 24 geführt.

Auf der Rückseite ist der Kabinett-Rahmen 10 durch einen Rückwand-Bauteil 12 abgeschlossen. Wie aus Fig.9 ersichtlich ist, enthält der Rückwand-Bauteil einen Rahmen 184 für Steckerverbindungen, eine Verteiler-Leiterplatte 186, eine Filter-Leiterplatte 188 und eine LEMP-Leiterplatte 190. Die Leiterplatten 186, 188 und 190 sind auf der Rückseite durch eine Rückwand 192 abgedeckt. Der Rahmen 184 ist über Abstandshülsen 192 und Schrauben 194 im Abstand von der Verteiler-Leiterplatte 186 gehalten. In dem Rahmen sind (nicht dargestellte) Stecker-Verbindungen gehaltert, die mit entsprechenden Gegenstücken der Einschub-Module 24 zusammenwirken. Die rahmenseitigen Teile der den verschieden Einschub-Modulen 24 zugeordneten Stecker-Verbindungen sind über die Verteiler-Leiterplatte 86 in geeigneter Weise miteinander verbunden. Die Filter-Leiterplatte 188 enthält integrierte HF-Filter, durch welche eine Abschirmung der durchgefühten Leiter gegen HF-Felder erfolgt. Die LEMP-Leiterplatte 190 dient dem Blitzschutz. Die verschiedenen Leiterplatten 186, 188, 190 werden durch Schrauben 196 und Abstandsstücke 198 aneinander bzw. an der Rückwand 190 gehaltert. Der Rahmen 184 und die Leiterplatten 186,188 und 190 sitzen in dem von den Seitenwänden 22 gebildeten RahmenDie Rückwand 190 ist mit je einem Flansch von L-Profilleisten 200 verbunden, die mit dem jeweils anderen Flansch innen an die vertikalen Seitenwände 22 angeschraubt sind.

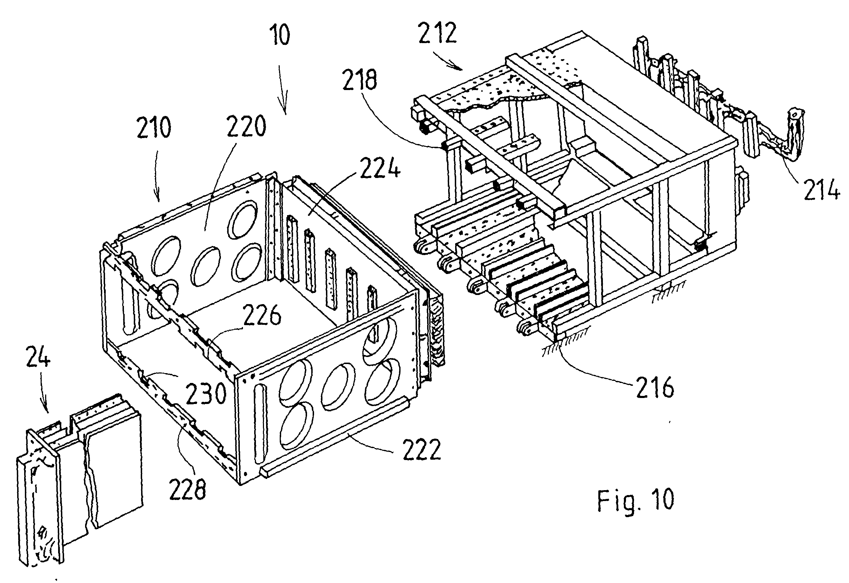

Bei der Ausführung nach Fig.10 besteht der Kabinett-Rahmen 10 aus zwei Teilen 210 und 212. Der Teil 212 ist strukturfest, z.B. flugzeugfest, montiert und mit der strukturfesten Verdrahtung 214, z.B. der Flugzeugverdrahtung, verbunden. Der Teil 212 enthält oben und unten Führungen 216 bzw. 218 für die Einschub-Module 24. Der Teil 210 enthält vertikale Seitenwände 220 und 222 und einen Rückwand-Bauteil 224.

Die vertikalen Seitenwände 220, 222 sind an der Vorderseite oben und unten durch Querstreben 226 und 228 miteinander verbunden. Die Querstreben 226 und 228 weisen Ausnehmungen 230 auf, welche das Einschieben der Einschub-Module 24 in die Führungen 216 und 218 gestatten. Nach oben und unten hin ist der Teil 210 offen. Die Einschub-Module 24 sind nach Einschieben des Teils 210 in den Teil 212 in den Führungen 216 und 218 des feststehenden Teils 212 geführt.

Der Rückwand-Bauteil 224 kann nach dem Herausziehen des Teils 210 aus dem feststehenden Teil 212 des Kabinett-Rahmens 10 gesondert auf Blitzschutz (LEMP) und elektromabgetische Störungen (EMI) geprüft werden.

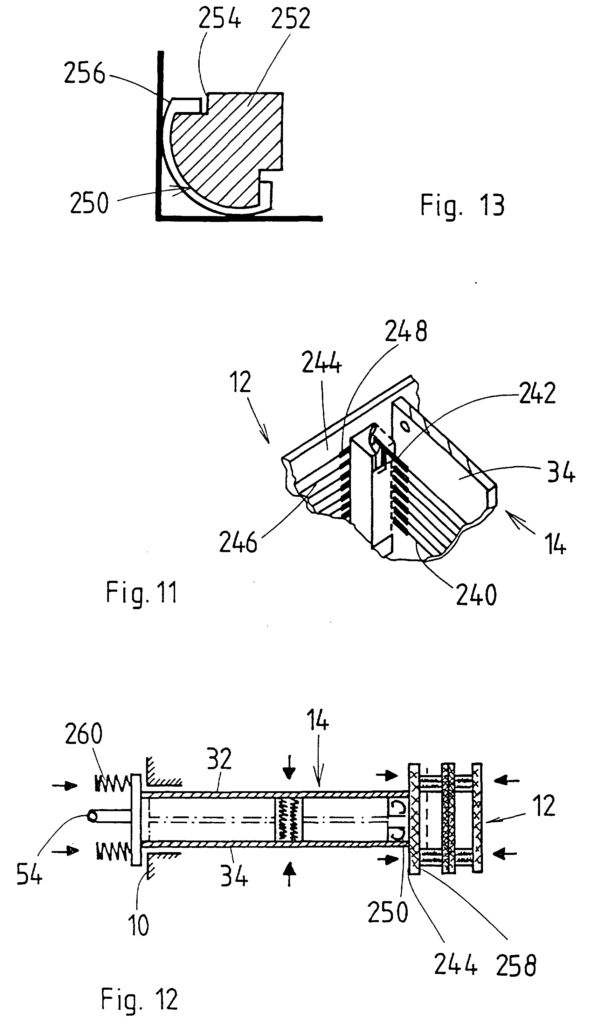

Wie aus Fig.11 bis 13 ersichtlich ist, wird die elektrische Verbindung zwischen dem Einschub-Modul und der Rückwand-Baugruppe nicht über Steckverbindungen mit Stecker-Stiften und Stecker-Buchsen sondern über Oberflächen-Kontakte hergestellt, die federnd gegeneinandergedrückt werden.

In Fig.11 ist mit 34 eine Leiterplatte eines Einschub-Moduls 14 bezeichnet. Auf der Leiterplatte 34 sind Leiterbahnen 240 auf, die in je einer Kontaktfläche 242 endet. Auf einer Leiterplatte 244 der Rückwand-Baugruppe 12 sind ebenfalls Leiterbahnen 246 gebildet, die in Kontaktflächen 248 auslaufen. Die Leiterplatten 34 und 244 stehen senkrecht zueinander. Die Stirnfläche der Leiterplatte 34 liegt bei eingeschobenem Einschub-Modul 14 an der Leiterplatte 244 an. Die Kontaktflächen 242 der Leiterplatte 34 bilden eine sich längs der Kante der Leiterplatte 34 erstreckende Reihe. Die Kontaktflächen 248 der Leiterplatte 244 bilden ebenfalls eine Reihe, die sich im Abstand längs der Kante der Leiterplatte 34 erstreckt, wobei jeder Kontaktfläche 242 eine der Kontaktflächen 248 benachbart ist. Die elektrische Verbindung zwischen den benachbarten Kontaktflächen 242 und 248 wird durch federnden Oberflächen-Kontakt über einen Kontakt-Körper 250 hergestellt.

Der Aufbau des (an sich bekannten) Kontakt-Körpers 250 ist am besten aus Fig.12 und 13 ersichtlich. An einer Trägersäule 252 sind Längsnuten 254 angebracht. In diesen Längsnuten sitzen bogenförmige, federnde Kontaktstreifen 256. Jeder dieser Kontaktstreifen 256 legt sich einerseits federnd an eine der Kontaktflächen 242 der Leiterplatte 34 und andererseits an die dazu benachbarte Kontaktfläche 248 der Leiterplatte 244 an. Dadurch wird durch Oberflächen-Kontakt die elektrische Verbindung zwischen den Leiterbahnen 240 und den zugehörigen Leiterbahnen 246 hergestellt.

Fig.12 zeigt schematisch das Einschub-Modul 14 mit den beiden Leiterplatten 32 und 34 und dem Rückwand-Bauteil 12. Die Leiterplatte 244 ist über Abstandsstücke 258 abgestützt. Jede der Leiterplatten 32 und 34 ist über eine Kontakt-Anordnung mit Oberflächen-Kontakten nach Art von Fig.11 und 13 mit der Leiterplatte 244 elektrisch verbunden. Das Einschub-Modul 14 rastet so in dem Kabinett-Rahmen ein, daß die zusammenwirkenden Teile der Oberflächen-Kontakte mit Vorspannung aneinander anliegen. Das ist in Fig.12 durch die Federn 260 angedeutet.

Statt der beschriebenen Kontakt-Anordnung kann auch eine geeignete andere Kontakt-Anordnung verwendet werden, die eine elektrische Verbindung über Oberflächen-Kontakte herstellt.

## Patentansprüche

1. Elektronisches Gerät in Modulbauweise mit Leiterplatten (32,34;60,62;86,88126,128), die elektronische Bauteile tragen, bei welchem die Leiterplatten (32,34;60,62;86,88126,128) parallel zueinander in einem Modul-Rahmen in Einschub-Modulen (14) angeordnet sind, welche ihrerseits nebeneinander in einen Kabinett-Rahmen (10) herausziehbar gehaltert sind, wobei die Einschub-Module (14) mit einer Rückwand-Baugruppe (12) elektrisch verbunden sind, wobei
(a) der Modul-Rahmen von einem rechteckigen Rahmenteil (24) gebildet ist,
(b) Leiterplatten (32,34;60,62;86,88126,128) als Strukturteile des Einschub-Moduls (14) auf beiden Seiten auf den Rahmenteil (24) aufgesetzt sind, und
(c) in die Leiterplatten (32,34;60,62;86,88126,128) Wärmeableit-Mittel zur Ableitung von Wärme von den Bauteilen integriert sind,
**dadurch gekennzeichnet, daß**
(d) die Leiterplatten (32,34;60,62;86,88126,128) einander zugewandten Bestückungsseiten (38,40) aufweisen, und
(e) die Wärmeableit-Mittel wärmeleitende Metallflächen (68) auf den einander zugewandten Bestückungsseiten der Leiterplatten (66,68) aufweisen, die wiederum durch wärmeleitende, metallische Flächen (70) mit wärmeerzeugenden Bauteilen (64) verbunden sind, und mit diesen Metallflächen (68) wärmeleitend verbundene Wärmesenken (72).

2. Elektronisches Gerät nach Anspruch 1, **dadurch gekennzeichnet**, daß die Wärmesenken (72) von wärmeleitenden Brückenteilen gebildet sind, die sich zwischen gegenüberliegenden Metallflächen (68) einander zugewandter Bestückungsseiten der benachbarten Leiterplatten (66,68) erstrecken.

3. Elektronisches Gerät nach Anspruch 2, **dadurch gekennzeichnet,** daß die als Wärmesenken (72) dienenden Brückenteile mit Kühlrippen versehen sind.

4. Elektronisches Gerät nach Anspruch 2 oder 3, **dadurch gekennzeichnet**, daß die mit den Wärmesenken verbundenen Metallflächen (68) sich durch die Leiterplatten (66,68) hindurch erstrecken und mit auf den unbestückten Außenseiten der Leiterplatten vorgesehenen Metallflächen (80) wärmeleitend verbunden sind.

5. Elektronisches Gerät nach Anspruch 5, dadurch gekennzeichnet, daß die Leiterplatten (66,68) auf den Außenseiten wärmeleitende Metallschichten (82,84) aufweisen.

6. Elektronisches Gerät nach einem der Ansprüche 1 bis 5, **dadurch gekennzeichnet, daß** auf jeder Leiterplatte (86,88) Bereiche mit weiter vorstehenden Bauteilen jeweils Bereichen mit weniger weit vorstehenden Bauteilen der anderen Leiterplatte gegenüberliegen, wobei die Leiterplatten so dicht benachbart angeordnet sind, daß sich in Längsrichtung der Leiterplatten gesehen die weiter vorstehenden Bauteile überlappen.

7. Elektronisches Gerät nach Anspruch 7, **dadurch gekennzeichnet, daß** die beiden Leiterplatten (86,88) übereinstimmend ausgebildet sind, wobei auf jeder Leiterplatte die Bereiche mit weiter vorstehenden Bauteilen in Bezug auf eine Mittellinie (94,96) symmetrisch zu Bereichen mit weniger weit vorstehenden Bauteilen angeordnet sind.

8. Elektronisches Gerät nach einem der Ansprüche 1-7, **dadurch gekennzeichnet, daß** auf den Außenseiten der Leiterplatten (126,128) Sandwich-Platten (146,148) angebracht sind, die aus durch eine Wellenstruktur (156,158) verbundenen Metall-Schichten (150,152,154) besteht, wobei die Wellenstruktur mit den Metall-Schichten vertikale Kanäle (160) bildet.

9. Elektronisches Gerät nach Anspruch 8, **dadurch gekennzeichnet, daß** die Metall-Schichten (150,152,156) Aluminium-Schichten sind.

10. Elektronisches Gerät nach Anspruch 8 oder 9, **dadurch gekennzeichnet, daß** die Leiterplatten (126,128) auch auf den Außenseiten mit Bauteilen (144) bestückt sind und die auf den Außenseiten montierten Bauteile (144) in Ausnehmungen (162) der Sandwich-Platten (146,148) hineinragen.

11. Elektronisches Gerät nach einem der Ansprüche 1 bis 10, **dadurch gekennzeichnet, daß** die Ober- und Unterseite des im Querschnitt rechteckige Kabinett-Rahmens (10) von perforierten Platten (22) gebildet ist.

12. Elektronisches Gerät nach einem der Ansprüche 1 bis 11, **dadurch gekennzeichnet, daß** die Rückwand-Baugruppe (12) von einer sich quer über den Kabinett-Rahmen (10) erstreckenden Kontaktanordnung (184), einer dahinter angeordneten Verteiler-Leiterplatte (186), über welche Verbindungen zwischen den Einschub-Modulen (14) hergestellt sind, einer dahinter angeordneten Filter-Leiterplatte (188) mit integrierten HF-Filtern, und einer dahinter angeordneten LEMP-Leiterplatte (190) besteht.

13. Elektronisches Gerät nach Anspruch 12, **dadurch gekennzeichnet, daß**
(a) der Kabinett-Rahmen aus einem strukturfesten, mit einer strukturfesten Verdrahtung verbundenen Teil (212) und einem in diesm strukturfesten Teil (212) herausziehbar gehaltenen Teil (210) besteht,
(b) der herausziehbare Teil (210) den Rückwand-Bauteil (224) enthält und auf der Ober- und Unterseite offen ist, und
(c) der strukturfeste Teil (212) die Führungen für die Einschub-Module (14) aufweist.

14. Elektrotechnisches Gerät nach einem der Ansprüche 1 bis 13, **dadurch gekennzeichnet, daß** die elektrische Verbindung der Module mit der Rückwand-Baugruppe über federnd angedrückte Oberflächen-Kontakte herstellbar ist.

## Claims

1. Electronical device in modular construction having printed circuit boards (32,34;60,62;86,88;126,128) carrying electronical components, in which the printed circuit boards (32,34;60,62;86,88;126,128) are arranged parallelly to each other in insert modules (14) in a module frame, the insert modules (14) being supported removably side-by-side in a cabinet frame (10) and being electrically connected to a rear wall unit (12),
(a) the module frame being formed by a rectangular frame element (24),
(b) printed circuit boards (32,34;60,62;86,88;126,128) being placed as structure elements of the insert module (14) on both sides of the frame element (24), and
(c) heat dissipation means for carrying-off heat from the components being integrated in the printed circuit boards (32,34;60,62;86,88;126,128),
**characterized in that**
(d) the printed circuit boards (32,34;60,62;86,88;126,128) have components sides (38,40) facing each other, and
(e) the heat dissipation means have heat conductive metal surfaces (68) on the components sides of the printed circuit boards (66,68) facing each other, which metal surfaces (68) are connected to heat generating components (64) again through heat conducting metal surfaces (70), and heat sinks (72) in heat-conductive connection with these metal surfaces (68).

2. Electronical device as set forth in claim 1, **characterized in that** the heat sinks (72) are heat conductive bridge elements which extend between opposite metal surfaces (68) of components sides of the adjacent printed circuit boards (32,34;60,62;86,88;126,128).

3. Electronical device as set forth in claim 2, **characterized in that** the bridge elements serving as heat sinks (72) are provided with cooling ribs.

4. Electronical device as set forth in claim 2 or 3, **characterized in that** the metal surfaces (68) connected to the heat sinks extend through the printed circuit boards (66,68) and are in heat-conductive connection with metal surfaces (80) provided on the non-component outsides of the printed circuit boards.

5. Electronical device as set forth in claim 5, **characterized in that** the printed circuit boards (66,68) has heat conductive metal layers (82,84) on the outsides.

6. Electronical device as set forth in anyone of the claims 1 to 5, **characterized in that**, on each printed circuit boards (86,88), areas having components projecting of relatively large height are opposite areas of the other printed circuit board having components projecting of relatively small height, the printed circuit boards being arranged so closely adjacent, that the projecting components overlap, as viewed in longitudinal direction of the printed circuit boards.

7. Electronical device as set forth in claim 7, **characterized in that** the two printed circuit boards (86,88) are substantially identical and, on each printed circuit board, the areas having components projecting of relatively large height are arranged symmetrically with respect to a center line (94,96) to areas having components projecting of relatively small height.

8. Electronical device as set forth in anyone of the claims 1-7, **characterized in that** sandwich plates (146,148) consisting of metal layers (150,152,154) connected by a wave structure (156, 158) are attached to the outsides of the printed circuit boards (126,128), the wave structure forming vertical passages (160) with the metal layers.

9. Electronical device as set forth in claim 8, **characterized in that** the metal layers (150,152,156) are aluminum layers.

10. Electronical device as set forth in claim 8 or 9, **characterized in that** the printed circuit boards (126,128) also have components (144) on the outsides and the components (144) provided on the outsides project into recesses (162) in the sandwich plates (146,148).

11. Electronical device as set forth in anyone of the claims 1 to 10, **characterized in that** the top side and the bottom side of the cabinet frame (10) of rectangular cross-section are formed by perforated plates (22).

12. Electronical device as set forth in anyone of the claims 1 to 11, **characterized in that** the rear wall unit (12) consists of a contact arrangement (184) extending transversely over the cabinet frame (10), a distribution printed circuit board (186) which is arranged behind the contact arrangement (184) and through which connections are made between the insert modules (14); a filter printed circuit board (188) arranged behind the distribution printed circuit board (186) and having integrated HF-filters; and a LEMP printed circuit board (190) arranged behind the filter printed circuit board (188).

13. Electronical device as set forth in claim 12, **characterized in that**
(a) the cabinet frame consists of a structure-fixed portion (212) connected to a structure-fixed wiring and a portion (210) mounted removably in this structure-fixed portion (212),
(b) the removably portion (210) comprises the rear wall unit (224) and is open on the top side and the bottom side, and
(c) the structure-fixed portion (212) has the guidances for the insert modules (14).

14. Electronical device as set forth in anyone of the claims 1 to 13, **characterized in that** the electrical connections of the modules to the rear wall unit is made through surface contacts pressed out resiliently.

## Revendications

1. Appareil électronique de conception modulaire muni de circuits imprimés (32,34 ; 60,62 ; 86,88; 126,128) portant des composants électroniques pour lequel les circuits imprimés (32,34 ; 60,62 ; 86,88; 126,128) se trouvent dans des modules enfichables (14), maintenus de leur côté les uns à côté des autres dans un cadre d'installation (10) de façon susceptible d'être retirés, et sont disposés parallèlement les uns aux autres dans un cadre de module, les modules enfichables (14) étant connectés électriquement à un bloc arrière (12),
(a) le cadre de module étant formé par un élément de cadre rectangulaire (24),
(b) des circuits imprimés (32,34 ; 60,62 ; 86,88; 126,128) étant placés, en tant qu'éléments structurants du module enfichable (14), sur l'élément de cadre (24) des deux côtés, et
(c) des moyens de dissipation de chaleur destinés à dissiper la chaleur des composants étant intégrés dans les circuits imprimés (32,34 ; 60,62 ; 86,88; 126,128),
**caractérisé par le fait que**
(d) les circuits imprimés (32,34 ; 60,62 ; 86,88; 126,128) présentent des côtés composants (38,40) se faisant face, et
(e) les moyens de dissipation de chaleur présentent des surfaces dé métal conductrices de chaleur (68) sur les côtés composants se faisant face des circuits imprimés (66,68) qui sont reliées à leur tour, grâce à des surfaces métalliques conductrices de chaleur (70), à des composants générateurs de chaleur (64), ainsi que des puits de chaleur (72) reliés à ces surfaces métalliques (68) de façon susceptible de conduire la chaleur.

2. Appareil électronique selon la revendication 1,
**caractérisé par le fait** que les puits de chaleur (72) sont formés par des éléments en pont conducteurs de chaleur qui s'étirent entre des surfaces de métal (68) opposées des côtés composants se faisant face des circuits imprimés adjacents (66,68).

3. Appareil électronique selon la revendication 2,
**caractérisé par le fai**t que les éléments en pont servant de puits de chaleur (72) sont pourvus de nervures de refroidissement.

4. Appareil électronique selon la revendication 2 ou 3,
**caractérisé par le fait** que les surfaces de métal (68) reliées aux puits de chaleur s'étirent à travers les circuits imprimés (66,68) et sont reliées à des surfaces de métal (80) prévues sur les côtés extérieurs sans composants des circuits imprimés de façon susceptible de conduire la chaleur.

5. Appareil électronique selon la revendication 5,
**caractérisé par le fait** que les circuits imprimés (66,68) présentent sur les côtés extérieurs des couches de métal conductrices de chaleur (82,84).

6. Appareil électronique selon l'une des revendications 1 à 5, **caractérisé par le fait** que des zones munies de composants d'une certaine hauteur peuvent, sur chaque circuit imprimé (86,88), être à chaque fois opposées à des zones munies de composants de hauteur moindre de l'autre circuit imprimé, les circuits imprimés étant disposés si proche les uns des autres que les composants d'une certaine hauteur se superposent, ceci considéré dans le sens longitudinal des circuits imprimés.

7. Appareil électronique selon la revendication 7,
**caractérisé par le fait** que les deux circuits imprimés (86,88) sont configurés de façon à concorder l'un avec l'autre, les zones munies de composants d'une certaine hauteur étant disposées sur chaque circuit imprimé par rapport à une ligne médiane (94,96) symétriquement par rapport aux zones munies de composants de moindre hauteur.

8. Appareil électronique selon l'une des revendications 1-7, **caractérisé par le fait** que des plaques sandwich (146,148) sont placées sur les côtés extérieurs des circuits imprimés (126,128), plaques se composant de couches de métal (150,152,154) reliées par une structure ondulée (156,158), la structure ondulée formant avec les couches de métal des canaux verticaux (160).

9. Appareil électronique selon la revendication 8,
**caractérisé par le fait** que les couches de métal (150,152,156) sont des couches d'aluminium.

10. Appareil électronique selon la revendication 8 ou 9,
**caractérisé par le fait** que les circuits imprimés (126,128) sont également munis de composants (144) sur les côtés extérieurs et les composants (144) montés sur les côtés extérieurs émergent à l'intérieur d'évidements (162) des plaques sandwich (146,148).

11. Appareil électronique selon l'une des revendications 1 à 10, **caractérisé par le fait** que le côté inférieur et supérieur du cadre d'installation (10) rectangulaire dans sa coupe transversale est formé par des plaques perforées (22).

12. Appareil électronique selon l'une des revendications 1 à 11, **caractérisé par le fait** que le bloc arrière (12) se compose d'une disposition de contacts (184) s'étirant à travers le cadre d'installation (10), d'un circuit imprimé répartiteur (186) disposé derrière cette dernière et par l'intermédiaire duquel des connexions entre les modules enfichables (14) sont établies, d'un circuit imprimé filtre (188) disposé derrière ce dernier et muni de filtres HF intégrés et d'un circuit imprimé LEMP (190) disposé derrière celui-ci.

13. Appareil électronique selon la revendication 12,
**caractérisé par le fait que**
(a) le cadre d'installation se compose d'un élément (212) fixe par rapport à la structure relié à un câblage fixe par rapport à la structure et d'un élément (210) maintenu dans cet élément (212) fixe par rapport à la structure de façon susceptible d'être retiré,
(b) l'élément susceptible d'être retiré (210) comprend l'élément arrière (224) et est ouvert sur le côté supérieur et inférieur, et
(c) l'élément fixe par rapport à la structure (212) présente les guidages destinés aux modules enfichables (14).

14. Appareil électrotechnique selon l'une des revendications 1 à 13, **caractérisé par le fait** que la connexion électrique des modules avec le bloc arrière est susceptible d'être établie par l'intermédiaire de contacts superficiels compressés élastiquement.
